# EUROPÄISCHE PATENTANMELDUNG

(11) **EP 1 770 784 A1**
(43) Veröffentlichungstag der Anmeldung: **04.04.2007**
(21) Anmeldenummer: 06020195.1
(22) Anmeldetag: 27.09.2006
(51) Int. Cl.: H01L 29/78, H01L 27/12, H01L 21/336, H01L 21/84, H01L 21/768, H01L 21/74, H01L 21/762, H01L 29/786

(54) **Halbleiteranordnung und Verfahren zur Herstellung einer Halbleiteranordnung**

(30) Priorität: 29.09.2005 DE 102005046624
(71) Anmelder: ATMEL Germany GmbH, 74072 Heilbronn (DE)
(72) Erfinder: Schwantes, Stefan, Dr., 74080 Heilbronn (DE); Graf, Michael, Dr., 71397 Leutenbach (DE); Florian, Tobias, 70569 Stuttgart (DE)

(57) **Zusammenfassung**

Halbleiteranordnung,
- mit einem Bauelementebereich (400),
- mit einem leitfähigen Substrat (100),
- mit einer vergrabenen Isolatorschicht (200), die den Bauelementebereich (400) gegenüber dem leitfähigen Substrat (100) isoliert,
- mit zumindest einem, mit einem Isolationsmaterial (710) gefüllten Graben (700), der zumindest ein Bauelement (1000) im Bauelementebereich (400) von weiteren Bauelementen im Bauelementebereich (400) isoliert,
- mit einem elektrischen Leiter (750), der mit dem leitfähigen Substrat (100) leitend verbunden ist,
- bei der der elektrische Leiter (750) durch das Isolationsmaterial (710) isoliert in dem Graben (700) angeordnet ist, und
- bei der der Graben (700) innerhalb einer Vertiefung (600) in einer Oberfläche ausgebildet ist.

Weiterhin ist ein Verfahren zur Herstellung einer Halbleiteranordnung angegeben.

## Beschreibung

Die vorliegende Erfindung betrifft eine Halbleiteranordnung, einen Schaltkreis und ein Verfahren zur Herstellung einer Halbleiteranordnung.

Aus der DE 102 60 616 B3 ist ein Verfahren zum Herstellen eines Halbleiterbauelements bekannt. Dabei wird eine Bauelementstruktur auf einem Wafer gebildet, wobei der Wafer ein rückseitiges Halbleitersubstrat, eine vergrabene Isolatorschicht und eine oben liegende Halbleiterschicht umfasst. Eine Ätzstoppschicht wird auf dem Wafer gebildet. Der Wafer trägt die Bauelementstruktur. Ein Fenster wird in der Ätzstoppschicht ausgebildet. Eine dielektrische Schicht wird auf der Ätzstoppschicht ausgebildet, die das darin gebildete Fenster aufweist. Danach erfolgt ein simultanes Ätzen eines ersten Kontaktloches durch die dielektrische Schicht und das Fenster bis hinunter zu dem rückseitigen Halbleitersubstrat und wenigstens eines zweiten Kontaktloches durch die dielektrische Schicht bis hinunter zu der Bauelementstruktur.

Bei der Herstellung von Halbleiterbauelementen werden SOI-Wafer oder SOI-Substrate verwendet, um eine höhere Isolation zwischen benachbarten Bauelementen in einem integriertem Schaltkreis verglichen mit Bauelementen bereitzustellen, die in Bulk-Wafer ausgebildet worden sind. SOI-Substrate sind Silizium-Wafer mit einer dünnen Schicht aus einem Oxid oder aus anderen Isolatoren, die darin vergraben ist. Bauelemente werden innerhalb einer dünnen Siliziumschicht oberhalb des vergrabenen Oxids hergestellt. Die erhöhte Isolation, die dadurch erzielt wird, kann den "Latch-Up" in CMOS-Bauelementen (CMOS: Complementary Metal Oxide Semiconductor) eliminieren und reduziert weiterhin parasitäre Kapazitäten. Zusätzlich zu der vergrabenen Oxidschicht wird häufig STI (Shallow Trench Isolation) verwendet, um Transistoren oder andere Bauelemente lateral voneinander vollständig zu isolieren.

Da das rückwärtige Siliziumsubstrat von den Bauelementen mittels des vergrabenen Oxids vollständig entkoppelt ist, tendiert das Potential des Rückseitensubstrats zum Floaten während des Betriebs des Schaltkreises. Dies kann elektrische Eigenschaften des Schaltkreises beeinflussen und die Betriebszuverlässigkeit reduzieren.

Um zu verhindern, dass das rückwärtige Siliziumsubstrat des Bauelementes floatet, werden spezielle Kontakte gebildet, um das Rückseitensubstrat mit einer Metallschicht zu verbinden, die ein definiertes Potential aufweist. Zunächst wird von einer SOI-Struktur ausgegangen, die ein rückwärtiges Siliziumsubstrat, eine vergrabene Oxidschicht und eine oben liegende Siliziumschicht umfasst. Transistorstrukturen sind über der SOI-Struktur gebildet. Die oben liegende Siliziumschicht weist geätzte mit STI-Material gefüllte Isolationsgräben auf, um die Transistorstrukturen voneinander und von weiteren Bauelementen zu entkoppeln.

Über der oben liegenden Siliziumschicht, dem STI-Material der Isolationsgräben und den Transistorstrukturen ist beispielsweise eine Siliziumoxinitridschicht (SiON) abgeschieden, die in nachfolgenden Ätzprozessen als Stoppschicht verwendet wird. Ferner können zwischen dieser Ätzstoppschicht und der oben liegenden Siliziumschicht Silizide gebildet sein.

Ferner ist eine TEOS-Schicht (TEOS: Tetraethylorthosilikat) als Maskierungsschicht abgeschieden. Nachdem die Transistorstrukturen und der Kontaktstapel aus Siliziumoxinitrid (SiON) und Tetraethylorthosilikat (TEOS) gebildet worden sind, wird dann eine Fotolackschicht strukturiert, um eine Rückseitenkontaktmaske mit einer Öffnung zum Ätzen eines Kontaktes des rückwärtigen Siliziumsubstrats bereitzustellen.

Ist das Rückseitenkontaktmaskenstrukturmuster in der Fotolackschicht einmal definiert, wird der Stapel aus Tetraethylorthosilikat (TEOS), Siliziumoxinitrid (SiON), STI-Material und vergrabenem Oxid bis auf das rückwärtige Siliziumsubstrat heruntergeätzt. Durch diesen Ätzvorgang wird ein Kontaktloch gebildet. Das STI-Material des Isolationsgrabens ist durch die Bildung des Kontaktloches geteilt worden. Der Fotolack wird nun durch einen Plasmastrip und einen zusätzlichen nasschemischen Reinigungsschritt entfernt.

Ist das rückwärtige Kontaktloch einmal gebildet, findet die Bildung der Kontakte zum Verbinden der Transistorstrukturen statt. Dies wird einen anderen Fotolackschichtstrukturierungsprozess und einen getrennten Ätzschritt erfordern.

Der zuvor beschriebene Stand der Technik ist beispielsweise der DE 100 54 109 A1 entnehmbar. Ergänzend wird auf US 5,965,917 A hingewiesen, die sich ebenfalls mit der Problematik der Substratkontaktierung bei SOI-Strukturen befasst. Aus der US 2003/0094654 A1 sind zwei leitfähige, von einer vergrabenen Oxidschicht voneinander isolierte Substratschichten als Leitungsschienen bekannt, die jeweils durch einen tiefen Graben kontaktiert sind.

Aus der EP 1 120 835 A2 ist eine Durchkontaktierung durch eine vergrabene isolierende Schicht in ein Halbleiter-Substrat bekannt. Dabei verbindet die Durchkontaktierung die Sourceregion eines Feldeffekttransistors mit dem unterhalb der vergrabenen isolierenden Schicht ausgebildeten Halbleitersubstrat-Substrat. Auch aus der DE 103 03 643 B3 ist ein Verfahren zur Herstellung von Substratkontakten bei SOI-Schaltungsstrukturen bekannt. Dabei sind mehrere Schichtfolgen einander überdeckende Metallisierungsschichten im Bereich der Kontaktierung ausgebildet. Eine Kontaktierung eines Siliziumsubstrats in einem dotierten Gebiet mittels Polysilizium ist hingegen in der WO 02/073667 A2 offenbart.

Aus der US 6,372,562 B1 ist eine Kontaktierung eines Substratbereiches durch eine dielektrische Schicht hindurch bekannt, wobei der kontaktierte Substratbereich durch einen in Sperrrichtung gepolten PN-Übergang von einem weiteren Substratbereich isoliert ist. Ebenfalls in der GB 2 346 260 A wird ein Verfahren zur Erzeugung eines Kontakts zu einem durch einen PN-Übergang isolierten Substratbereich in einem tiefen Graben eines SOI-Bauteils offenbart. Aus der EP 0 635 884 A1 ist ein Verfahren zur Herstellung eines Grabens in einem Substrat und dessen Verwendung in der Smart-Power-Technologie bekannt. Dabei wird nach Verstärkung einer Grabenmaske durch eine nicht konform abgeschiedene Schutzschicht in einer zweiten Grabenätzung die vergrabene isolierende Schicht bis auf das Siliziumsubstrat durchgeätzt. Ein weiteres Verfahren zur Herstellung einer Substratkontaktierung ist aus der US 6,632,710 B2 bekannt.

Der Erfindung liegt die Aufgabe zu Grunde eine Halbleiteranordnung und ein Verfahren zur Herstellung einer Kontaktierung eines Substrats mit einer möglichst erhöhten Prozesssicherheit weiter zu entwickeln.

Demzufolge ist eine Halbleiteranordnung vorgesehen. Diese Halbleiteranordnung weist einen Bauelementebereich, ein leitfähiges Substrat und eine vergrabene Isolatorschicht auf, wobei die Isolatorschicht den Bauelementebereich gegenüber dem leitfähigen Substrat isoliert. Eine derartige Anordnung mit einer vergrabenen Isolatorschicht, wird bei der Verwendung von Silizium als Halbleitermaterial auch als SOI (Silicon On Isolator) bezeichnet. Die vergrabene Isolatorschicht kann beispielsweise Siliziumdioxid aufweisen.

Die Halbleiteranordnung weist zumindest einen, mit einem Isolationsmaterial gefüllten Graben auf. Dieser Graben isoliert zumindest ein Bauelement im Bauelementebereich von weiteren Bauelementen im Bauelementebereich. Im Bauelementebereich werden die Bauelemente, wie Feldeffekttransistoren, ausgebildet. Hierzu weist der Bauelementebereich vorzugsweise einkristallines Halbleitermaterial, vorteilhafterweise Silizium mit vorzugsweise einer <100> Kristallorientierung auf.

Ein elektrischer Leiter ist mit dem leitfähigen Substrat leitend verbunden. Der elektrische Leiter ist durch das den Graben füllende Isolationsmaterial isoliert und innerhalb des Grabens angeordnet. Der Graben ist dabei bis zu einer Oberfläche ausgebildet. Der Graben ist innerhalb einer Vertiefung in der Oberfläche ausgebildet. Demzufolge grenzen sowohl der Graben als auch die Vertiefung an den Bauelementebereich an. Die Vertiefung in der Oberfläche ist vorzugsweise flacher als die Tiefe des Grabens. Weiterhin vorzugsweise ist die Vertiefung in der Oberfläche breiter als die Breite des Grabens. Besonders bevorzugt weist die Vertiefung in der Oberfläche ein kleineres Aspektverhältnis als der Graben auf. Das Aspektverhältnis ist dabei das Verhältnis der Tiefe des Grabens oder der Vertiefung zu seiner/ihrer Breite. Die Oberfläche ist vorzugsweise die dem Substrat abgewandte Oberfläche des Bauelementebereichs der Halbleiteranordnung.

Gemäß einer bevorzugten Ausgestaltung ist vorgesehen, dass der Graben nicht in einem Randbereich der Vertiefung, sondern in einem Mittenbereich, vorzugsweise in der Mitte der Vertiefung ausgebildet ist.

Zwar besteht die Möglichkeit die Vertiefung in der Oberfläche durch eine lokale Oxidation (LOCOS; LOCal Oxidation of Silicon) herzustellen, bevorzugt werden jedoch kleine Strukturen erzeugt. Hierzu ist in einer Weiterbildung der Erfindung vorgesehen, dass als Vertiefung ein flacher Graben vorgesehen ist. Dieser flache Graben ist vorzugsweise mit Dielektrikum verfüllt. Dies wird auch als STI (Shallow Trench Isolation) bezeichnet. Innerhalb dieses flachen Grabens (STI) ist der tiefe Graben (Deep Trench Isolation) mit einem höheren Aspektverhältnis ausgebildet. Bevorzugt sind beide Gräben im Halbleitermaterial des Bauelementebereichs geätzt.

Gemäß einer anderen vorteilhaften Weiterbildung ist ein Halbleitergebiet des zumindest einen Bauelementes selbst justiert zur Vertiefung in dem Bauelementebereich ausgebildet. Das Halbleitergebiet ist beispielsweise eine eindiffundierte Wanne mit einem Dotierstofftyp. Bevorzugt ist das Halbleitergebiet ein beispielsweise durch eine Implantation eines Dotierstoffs ausgebildetes Halbleiteranschlussgebiet. Durch die Selbstjustierung grenzt das Halbleitergebiet an die Vertiefung an.

Die Kontaktierung des leitfähigen Substrats kann dabei unterschiedlichen Funktionen dienen. Eine wichtige Funktion ist es, die Bauelementeparameter von auf der gegenüberliegenden Seite der vergrabenen Isolatorschicht angeordneten Bauelementen durch die Höhe oder den zeitlichen Verlauf des angelegten Substratpotentials zu verändern. Insbesondere kann die Durchbruchsspannung eines lateralen N-DMOS-Transistors oder eines P-DMOS-Transistors verbessert werden. Weiterhin kann durch die Höhe eines angelegten Substratpotentials eine Stromverstärkung eines NPN-Bipolartransistors verändert, insbesondere vergrößert werden. Dabei ist eine deutliche Verbesserung für positive Substratpotentiale zu erreichen. Weiterhin kann das Substrat zudem als Leitungsverbindung zu einem anderen Bauelement oder zu einem auf der Rückseite angeordneten Kontakt der integrierten Schaltung genutzt werden. Ebenso ist es möglich durch ein Einbringen von Dotanden in das Substrat, Halbleiterbauelemente, wie beispielsweise Dioden im Substrat auszubilden.

Das leitfähige Substrat kann eine Anzahl voneinander isolierten Substratbereichen aufweist. Diese Substratbereiche können beispielsweise durch eine tiefe Grabenätzung voneinander getrennt werden. Vorzugsweise werden diese tiefen Gräben dann mit einem Dielektrikum verfüllt. Jeder Substratbereich kann dabei unabhängig voneinander an ein separates, festes oder variables Potential angelegt werden, so dass getrennte Bauelemente im Bauelementebereich mit unterschiedlichen, angelegten Substratpotentialen betrieben werden können.

Bevorzugt ist dabei vorgesehen, dass die voneinander isolierten Substratbereiche jeweils mit zumindest einem in einem Graben angeordneten elektrischen Leiter leitend verbunden sind. Zusätzlich kann auch ein nicht kontaktierter Substratbereich vorgesehen sein.

Vorteilhafte Ausgestaltungen der Erfindung sehen vor, dass der elektrische Leiter ein hochdotiertes Halbleitermaterial und/oder ein Metall und/oder ein Silizid aufweist.

Unabhängig davon, ob der elektrische Leiter zur Substratkontaktierung vorgesehen ist, ist in einem anderen Aspekt der Erfindung eine Halbleiteranordnung vorgesehen, die einen Bauelementebereich, ein leitfähiges Substrat und eine vergraben Isolatorschicht aufweist, wobei die Isolatorschicht den Bauelementebereich gegenüber dem leitfähigen Substrat isoliert. Die Halbleiteranordnung weist zumindest einen, mit einem Isolationsmaterial gefüllten Graben auf, der zumindest ein Bauelement im Bauelementebereich von weiteren Bauelementen im Bauelementebereich isoliert. Dabei ist der Graben innerhalb einer Vertiefung in einer Oberfläche des Bauelementebereiches ausgebildet ist. Ebenfalls ein Aspekt der Erfindung ist die Verwendung des in der Vertiefung ausgebildeten Grabens zur lateralen Isolation eines Feldeffekttransistors (DMOS) für Hochvoltanwendungen.

Ein weiterer Aspekt der Erfindung ist ein Schaltkreis mit einer zuvor beschriebenen Halbleiteranordnung. Dieser Schaltkreis weist vorzugsweise einen lateralen DMOS-Feldeffekttransistor auf. Der Schaltkreis weist Mittel auf, um an den elektrischen Leiter ein konstantes oder steuerbares Potential anzulegen. Dabei ist von dem konstanten oder steuerbaren Potential zumindest eine elektrische Eigenschaft des Bauelementes abhängig. Ein derartiges Mittel ist beispielsweise eine Verbindung mit einem Versorgungspotential oder ein angeschlossener Potentialschieber.

Eine weitere der Erfindung zu Grund liegende Aufgabe ist es ein Herstellungsverfahren für eine Halbleiteranordnung anzugeben. Diese Aufgabe wird erfindungsgemäß durch ein Verfahren mit den Merkmalen des Anspruchs 7 gelöst. Bevorzugte Weiterbildungen des Verfahrens sind Gegenstand von Unteransprüchen.

Demgemäß ist ein Verfahren zur Herstellung einer Halbleiteranordnung vorgesehen. Bei diesem Verfahren werden ein leitfähiges Substrat, ein Bauelementebereich und eine den Bauelementebereich von dem leitfähigen Substrat isolierende Isolatorschicht ausgebildet. Ein derartiger Aufbau wird auch als SOI-Struktur (engl. Silicon-On-Insulator) bezeichnet. Der Bauelementebereich weist vorzugsweise einen monokristallinen Halbleiter zur Ausbildung von Halbleiterbauelementen auf. Ein geeignetes Halbleitermaterial ist beispielsweise Silizium, Germanium oder Mischkristalle, wie Gallium-Arsenid.

In einem Verfahrensschritt wird eine flache Vertiefung in eine Oberfläche des Bauelementebereiches geätzt. Die Ätzung erfolgt vorzugsweise mit einem kleinen Aspektverhältnis von Tiefe zu Breite der geätzten Vertiefung (STI). In einem späteren Verfahrensschritt wird innerhalb der flachen Vertiefung ein Graben in den Bauelementebereich bis zur Isolatorschicht durch das Halbleitermaterial des Bauelementebereichs geätzt. Die Ätzung erfolgt dabei vorzugsweise selektiv gegenüber Oxidschichten. Weiterhin wird für die Ätzung des Grabens vorzugsweise eine Ätzung verwendet, die ein hohes Aspektverhältnis von Tiefe zu Breite der Ätzung ermöglicht (Deep Trench).

Anschließend wird der tiefe Graben bis zum leitfähigen Substrat weiter geätzt. Dieser Ätzschritt erfolgt vorzugsweise gegenüber Halbleiterschichten, des Bauelementebereichs wie beispielsweise Siliziumschichten selektiv. Anschließend werden die Wände des Grabens mit einem Isolationsmaterial ausgebildet. Zur Ausbildung des Isolationsmaterials kann auf die Wandbereiche des Grabens beispielsweise ein Oxid abgeschieden werden. Bevorzugt wird zur Ausbildung des Isolationsmaterials jedoch ein an den Graben angrenzendes Siliziummaterial des Bauelementebereichs oxidiert. Vorzugsweise grenzt das Isolationsmaterial dabei an die vergrabene Isolatorschicht.

Nach den Ätzschritten wird vorzugsweise ein elektrischer Leiter in den durch das Isolationsmaterial gegenüber dem Silizium des Bauelementebereichs isolierten Graben eingebracht. Dabei wird der elektrische Leiter mit dem leitfähigen Substrat leitend verbunden.

Gemäß einer bevorzugten Weiterbildung der Erfindung ist vorgesehen, dass die flache Vertiefung mit Dielektrikum gefüllt wird. Nach dem Verfüllen mit Dielektrikum wird ein Dotierstoff - beispielsweise Bor - für ein Halbleitergebiet des zumindest einen Bauelementes eingebracht. Zur Einbringung kann der Dotierstoff beispielsweise eindiffundiert und/oder implantiert werden. Das Dielektrikum in der flachen Vertiefung dient dabei als Maskierung, um das Halbleitergebiet des zumindest einen Bauelementes selbst justiert zur Vertiefung in dem Bauelementebereich auszubilden. Zur Selbstjustierung weist das Dielektrikum beispielsweise eine derartige Dicke auf, dass beim Einbringen des Dotierstoffes dieser ausschließlich neben dem Dielektrikum in den Bauelementebereich eingebracht wird. Hingegen erfolgt im Wesentlichen kein Einbringen des Dotierstoffes in einem Bereich in der Nähe des tiefen Grabens unterhalb des Dielektrikums in der flachen Vertiefung. Ein Halbleitergebiet, das durch den eingebrachten Dotierstoff gebildet wird und dem zumindest einen Bauelement im Bauelementebereich zugeordnet ist, ist damit neben der flachen Vertiefung positioniert. Hierzu ist keine zusätzliche Maskenkante notwendig, so dass dies als Selbstjustierung bezeichnet werden kann.

Gemäß einer vorteilhaften Ausgestaltung der Erfindung ist vorgesehen, dass zur leitenden Verbindung des elektrischen Leiters mit dem leitfähigen Substrat das Isolationsmaterial, das den Boden des Grabens bedeckt, entfernt wird. Zur Entfernung wird dieses den Boden bedeckende Isolationsmaterial mittels eines Plasmaätzschrittes (ICP; engl. inductivecoupled-plasma) im Wesentlichen in vertikaler Richtung entfernt.

In einer vorteilhaften Weiterbildung der Erfindung ist vorgesehen, dass eine Menge von Bauelementen in dem Bauelementebereich nach der Ausbildung des Isolationsmaterials ausgebildet wird. Das thermische Budget zur Ausbildung der Bauelemente im Bauelementebereich kann daher Unabhängig von der Ausbildung des tiefen Graben erfolgen. Wird in den tiefen Graben ein Leiter aus Polysilizium eingebracht, kann dies vorteilhafterweise ebenfalls vor der Ausbildung der Halbleiterbauelemente erfolgen. Die Menge der Bauelemente ist dabei gegenüber einem oder mehreren Substratbereichen in vertikaler Richtung durch die vergrabene Isolatorschicht isoliert. Weiterhin ermöglicht das Isolatormaterial in den tiefen Gräben und Isolationsmaterial in der flachen Vertiefung eine laterale Isolation von zumindest zwei Bauelementen.

Die Erfindung bevorzugt weiterbildend wird zeitgleich zum Ätzen des Grabens zur Aufnahme des Leiters ein Isoliergraben geätzt, wobei der Isoliergraben mit einem Isolator vollständig verfüllt wird und ausschließlich der Isolation eines Bauelementes dient. Dies ermöglicht eine Reduktion der Anzahl der benötigten Ätzschritte insbesondere in das Halbleitermaterial des Bauelementebereichs. Zudem wird die Positionierungsgenauigkeit des tiefen Grabens für den Leiter zur Kontaktierung des Substrats und der weiteren tiefen Gräben zueinander verbessert.

Gemäß einer vorteilhaften Weiterbildung der Erfindung wird vor dem Ätzen des Grabens eine Schichtenfolge aus einer ersten Oxidschicht, einer Polysiliziumschicht oberhalb der ersten Oxidschicht und einer zweiten Oxidschicht oberhalb der Polysiliziumschicht auf den Bauelementebereich aufgebracht. Die Aufbringung erfolgt dabei zumindest innerhalb der flachen Vertiefung. Die Schichtenfolge soll einen Oberflächenbereich außerhalb des zu ätzenden tiefen Grabens gegen die Ätzangriffe schützen. In einer Ausgestaltung dieser Weiterbildung der Erfindung ist vorgesehen, dass die Polysiliziumschicht im Schritt zur Ausbildung des Isolationsmaterials mit oxidiert wird und somit die erste Oxidschicht in ihrer Dicke verstärkt.

In einer anderen Weiterbildung der Erfindung wird die zweite Oxidschicht zeitgleich mit der, im Graben offen liegenden vergrabenen Isolatorschicht geätzt. Die Ätzung wird daher an beziehungsweise in der Polysiliziumschicht als auch am beziehungsweise im Halbleitermaterial des Substrats gestoppt.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Eine mögliche Kombination ist in der Beschreibung des Ausführungsbeispiels in den Figuren erläutert. Diese dort dargestellte Kombinationsmöglichkeit der Weiterbildungsvarianten ist jedoch nicht abschließend.

Im Folgenden wird die Erfindung in einem Ausführungsbeispiel anhand einer Zeichnung mit den Figuren 1 bis 8 näher erläutert.

Dabei zeigen
- Fig. 1 bis Fig. 8: schematische Schnittansichten durch einen Wafer zu unterschiedlichen Prozesszeitpunkten der Herstellung einer Halbleiteranordnung, und
- Fig. 9: eine schematische Schnittansicht eines LDMOS-Feldeffekttransistors mit einer Verbindung zum Substrat.

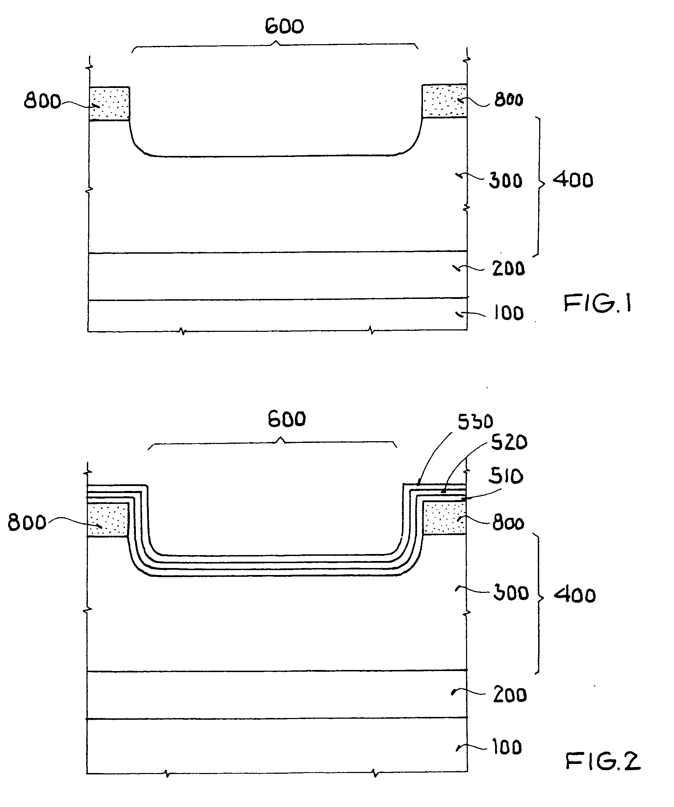

In den Figuren 1 bis 9 sind schematische Schnittansichten durch einen Wafer zu unterschiedlichen Prozesszeitpunkten der Herstellung einer Halbleiteranordnung dargestellt. Gleiche Strukturelemente sind in der Regel mit gleichen Bezugszeichen versehen.

In Fig. 1 ist ein Bauelementebereich 400 aus einem Halbleitermaterial, in diesem Fall aus Silizium 300, ein leitfähiges, n-dotiertes Siliziumsubstrat 100 und eine vergrabene Isolatorschicht 200 dargestellt. Die Isolatorschicht 200 isoliert den Bauelementebereich 400 von dem Siliziumsubstrat 100. Die Isolatorschicht 200 ist ein Dielektrikum beispielsweise aus Siliziumdioxid (SiO₂). Auf das Silizium 300 des Bauelementebereichs 400 ist zur Maskierung eine Hartmaske 800 aus Siliziumnitrid (Si₃N₄) aufgebracht. Eine Vertiefung 600 in Form eines flachen Grabens 600 (STI) ist in die Oberfläche des Bauelementebereichs 400 aus Silizium 300 geätzt, wobei Bereiche zur Ausbildung von Bauelementen durch die Hartmaske 800 vor dem Ätzangriff geschützt sind.

In Fig. 2 ist innerhalb des geätzten flachen Grabens 600 und auf der Hartmaske 800 eine Schichtenfolge aus einer ersten Siliziumoxidschicht 510 (SiO₂), einer Schicht aus Polykristallinem Silizium 520 (Poly-Si) und einer zweiten Siliziumdioxidschicht 530 (SiO₂) aufgebracht. Diese Schichtenfolge 510, 520, 530 wird auch als OPO-Schicht bezeichnet. Vorzugsweise werden diese Schichten 510, 520, 530 nacheinander, aufeinander folgend abgeschieden.

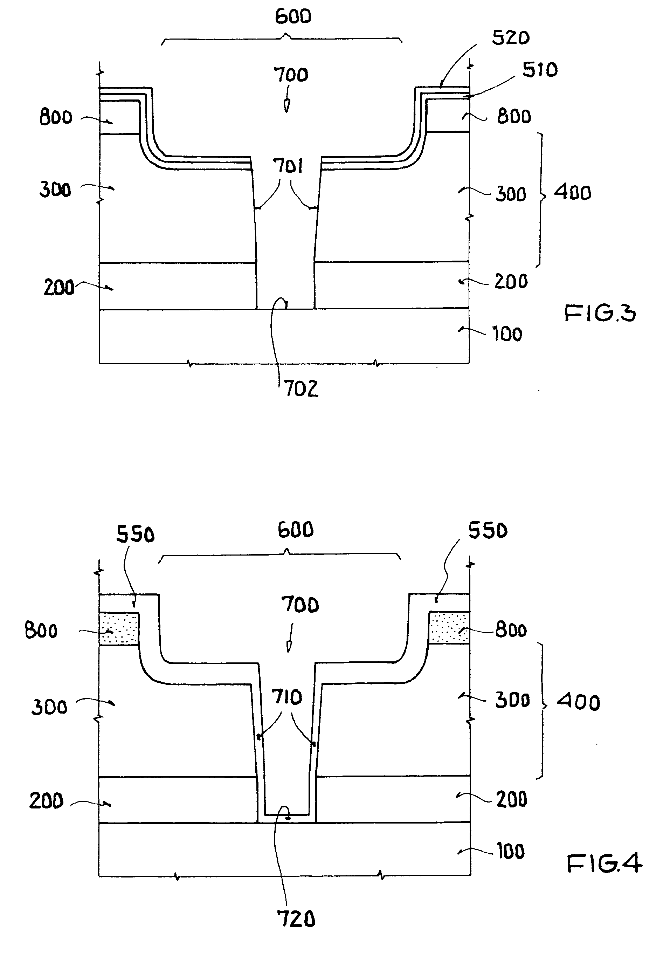

Die Schichtenfolge aus den Schichten 510, 520, 530 wird mittels eines Photolacks und einer Maske lithographisch derart strukturiert, dass eine vertikale Öffnung in die Schichtenfolge eingebracht wird. Durch diese vertikale Öffnung wird ein tiefer Graben 700 (engl. Deep Trench) geätzt. Diese Ätzung ist selektiv gegenüber der zweiten Oxidschicht 530 und trägt dabei im Wesentlichen nur das Silizium 300 ab. Hiernach wird das vergrabene Oxid 200 unterhalb der geätzten Öffnung entfernt. Zugleich wird auch die zweite Oxidschicht 530 mit entfernt. Fig. 3 zeigt den Zustand nach der Ätzung des vergrabenen Oxids 200 unterhalb der geätzten Öffnung und der zweiten Oxidschicht. Der tiefe Graben 700 weist Grabenwände 701 und einen Grabenboden 702 auf.

Nachfolgend wird im nächsten Prozessschritt ein thermisches Oxid in möglichst hoher Qualität, vorzugsweise mit einer Dicke von 50 nm hergestellt. Dabei wird an den Grabenwänden 701 und auf am Grabenboden 702 ein Oxidschicht 710 respektive 720 gebildet. Dieser Zustand ist in Fig. 4 schematisch dargestellt. Dabei wird Silizium-Material des Bauelementebereichs 400 im Wandungsbereich und Silizium-Material des Siliziumsubstrats 100 in Siliziumdioxid umgewandelt. Weiterhin wird die Polysiliziumschicht 520 ebenfalls in Siliziumdioxid umgewandelt, so dass zusammen mit der ersten Oxidschicht 510 eine dickere Siliziumdioxid-Deckschicht 550 zumindest innerhalb der flachen Vertiefung 600 auf dem Bauelementebereich 400 gebildet wird.

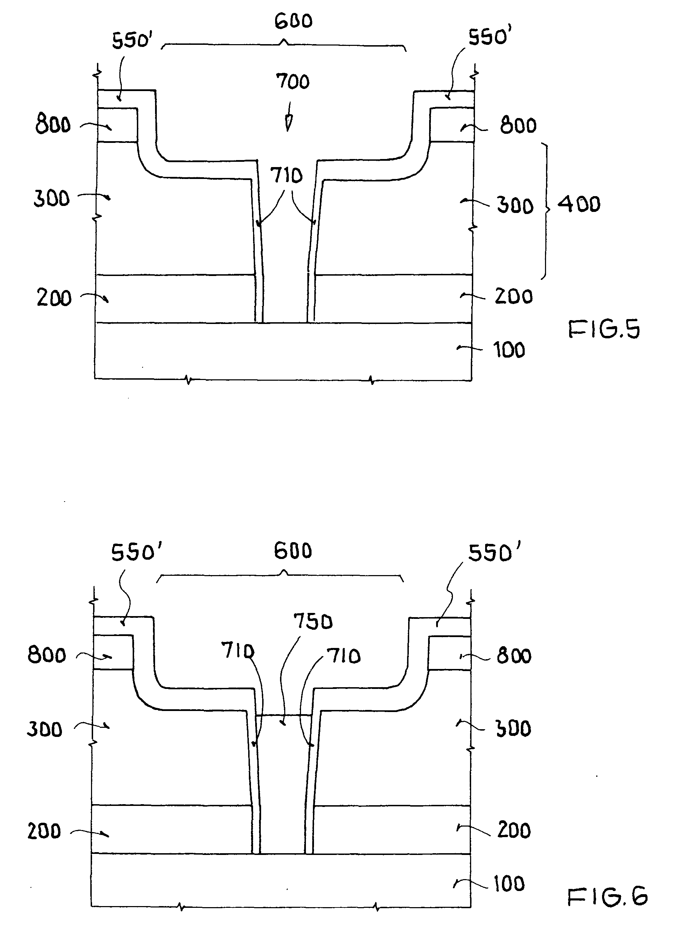

Im nächsten Prozessschritt wird mittels einer anisotropen Ätzung das Oxid 720 am Boden des tiefen Grabens 700 abgeätzt. Dieser Prozesszustand ist in Fig. 5 dargestellt. Dabei wird die Siliziumdioxid-Deckschicht 550' entsprechend gedünnt, jedoch nicht vollständig entfernt.

Anschließend wird konform Polysilizium 750 oder amorphes Silizium 750 auf dem Wafer abgeschieden und bis zum Eingang des tiefen Grabens 700 zurückgeätzt. Dieser Zustand ist in Fig. 6 dargestellt. Das Polysilizium 750 kann entweder bereits während der Abscheidung oder bei der späteren Kontaktöffnung durch Implantation dotiert werden. Der Dotierungstyp entspricht vorteilhafterweise dem des Siliziumsubstrats 100.

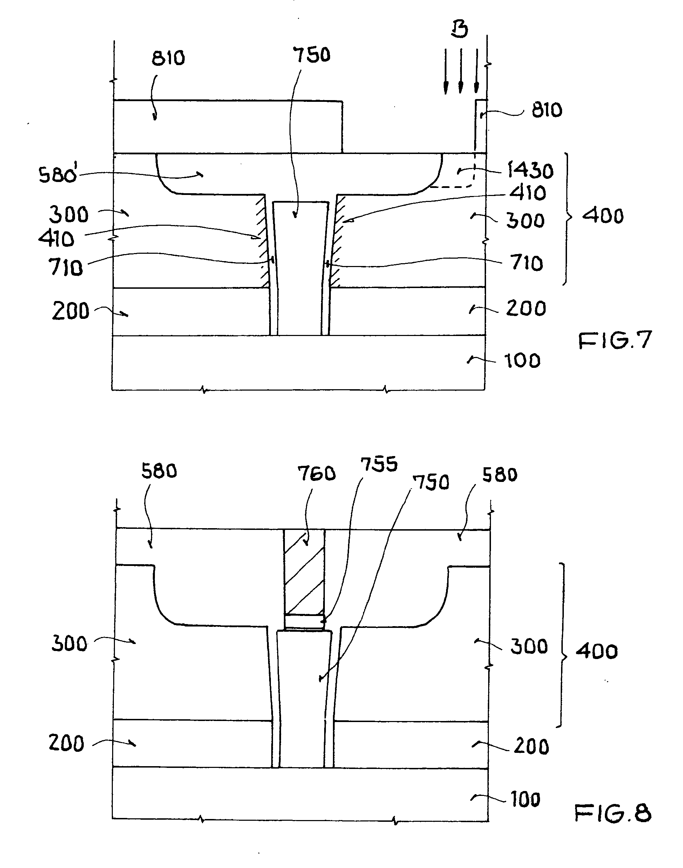

Nachfolgend wird zu Erzielung des Prozesszustands gemäß der Fig. 7 der flache Graben 600 mit Oxid 580' gefüllt, die Hartmaske (800) entfernt und die Waferoberfläche beispielsweise mittels chemisch-mechanischem Polierens (CMP) planarisiert. Die nächsten Verfahrensschritte dienen der Herstellung der Halbleiterbauelemente im Bauelementebereich 400. Dabei wird ein Resist 810 aufgebracht und als Implantationsmaske 810 photolithographisch strukturiert. Dabei bildet das Oxid 580' im flachen Graben 600 ebenfalls eine Maskierung, die das Halbleitermaterial 300 des Bauelementebereichs 400 im Bereich unterhalb des Oxids 580' vor dem zu implantierenden Dotierstoff schützt.

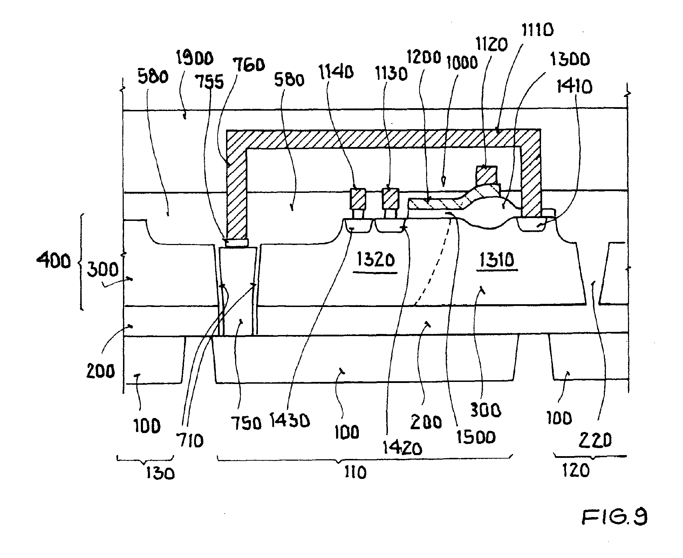

Die Maskierung durch das Oxid 580' bewirkt, dass ein Halbleitergebiet 1430 eines zugehörigen Bauelementes 1000 (siehe Fig. 9) an das Oxid 580' im flachen Graben 600 angrenzend ausgebildet wird. Das Halbleitergebiet 1430 wird dabei durch die Maskierung selbstjustierend zum flachen Graben 600 ausgerichtet. Im Ausführungsbeispiel der Fig. 7 wird Bor B als Dotierstoff implantiert, wobei das Halbleitergebiet 1430 beispielsweise als p-dotiertes Halbleiteranschlussgebiet mit einer hohen Dotierstoffkonzentration ausgebildet wird.

In einem Bereich des Bauelementebereichs 400, der an den flachen Graben 600 lateral angrenzt ist die Dichte der Kristallschäden im Bauelementebereich deutlich geringer als in einem Grenzbereich 410 des Bauelementebereichs 400, der lateral an den tiefen Graben 700 angrenzt. Der an das Oxid 710 angrenzende Grenzbereich 410 des Bauelementebereichs 400 kann eine hohe Dichte von Störungen im monokristallinen Kristallgitter aufweisen. Die Anordnung des tiefen Grabens innerhalb des flachen Grabens ermöglicht durch die Selbst justierung des Halbleitergebietes 1430 und damit durch die Selbstjustierung des Bauelementes 1000 einen sichergestellten Abstand zwischen dem tiefen Graben und aktiven Gebieten des Bauelementes 1000, so dass Prozessstreuungen reduziert werden könnten. Als ein weiterer möglicher Vorteil der Ausbildung des tiefen Grabens 700 innerhalb des flachen Grabens 600 kann das Bauelement 1000 eine verbesserte Durchbruchspannung aufweisen. Vorteilhafterweise ist die Breite des flachen Grabens 600 an eine mögliche Dejustage der Maskierung zur Ätzung des tiefen Grabens 700 angepasst.

Die Kontaktierung des Siliziumsubstrats 100 durch den tiefen Graben 700 (Kontaktgraben) wird erst nach Fertigstellung aller Bauelemente weiter prozessiert. Zur Kontaktierung der Polysiliziumfüllung 750 wird das Oxid 580 im flachen Graben 600 in einem lithographisch maskierten Ätzschritt über dem Polysilizium 750 entfernt. Die geätzte Oxidöffnung wird nun mit einer Diffusionsbarriere 755, beispielsweise aus einem Silizid und mit einem Metall 760, beispielsweise Wolfram gefüllt. Dieser Prozesszustand ist in Fig. 8 dargestellt.

Die Fig. 9 zeigt eine schematische Schnittansicht durch einen Wafer mit einem Leistungsbauelement 1000, das im Bauelementebereich 400 aufgebildet ist, und eine Kontaktierung des Siliziumsubstrats 100. Das Siliziumsubstrat 100 ist dabei in mehrere Substratbereiche 110, 120, 130 durch geätzte Gräben unterteilt. Ein Substratbereich 110 ist dabei unterhalb des Leistungsbauelementes 1000 ausgebildet. Das Leistungsbauelement 1000 ist durch den mit dem Polysilizium 750 gefüllten tiefen Graben (700) und durch zumindest eine weitere Grabenisolation 220 von benachbarten Bauelementen (in Fig. 9 nicht dargestellt) durch ein Dielektrikum 710, 220 insbesondere aus Siliziumdioxid isoliert.

Im Ausführungsbeispiel der Fig. 9 ist das Leistungsbauelement 1000 ein N-DMOS-Feldeffektransistor 1000. Dieser weist ein n-dotiertes Drainhalbleitergebiet 1410, eine N-Wanne 1310, die eine Driftzone ausbildet, eine P-Wanne 1320, die ein Bodyhalbleitergebiet ausbildet, ein n-dotiertes Sourcehalbleitergebiet 1420 und ein p-dotiertes Bodyanschlusshalbleitergebiet 1430 auf. Weiterhin weist der N-DMOS-Feldeffekttransistor 1000 ein Feld-Oxid 1300 und ein Gate-Oxid 1500 mit einer darauf angeordneten Gate-Elektrode 1200 aus Polysilizium auf.

Drainhalbleitergebiet 1410, Gate-Elektrode 1200, Sourcehalbleitergebiet 1420 und Bodyanschlusshalbleitergebiet 1430 sind mit jeweils eine Metallleiterbahn 1110, 1120, 1130 und 1140 leitend verbunden. In dem Ausführungsbeispiel der Fig. 9 ist der Substratbereich 110 über das Polysilizium 750, die Diffusionsbarriere 755, das Metall 760 und die Leiterbahn 1110 mit dem Drainhalbleitergebiet 1410 verbunden, so dass der Substratbereich 110 im Wesentlichen dasselbe Potential wie das Drainhalbleitergebiet 1410 aufweist. Der Wafer ist durch ein Bor-Phosphor-Silicat-Glas 1900 gegen äußere Einflüsse geschützt.

Alternativ zur Fig. 9 kann der Substratbereich 110 auch an ein anderes Bauelement zur Steuerung des Potentials des Substratbereichs 110 angeschlossen sein. Eine weitere Möglichkeit besteht darin, den Substratbereich 110 beispielsweise mittels eines Spannungsteilers aus zwei Kondensatoren an ein festes Potential anzuschließen.

Die Erfindung ist selbstverständlich nicht auf das dargestellte Ausführungsbeispiel beschränkt, sondern umfasst auch nicht dargestellte Ausführungsvarianten. Beispielsweise könnten das im Ausführungsbeispiel dargestellte Aspektverhältnis des flachen Grabens 600 und des tiefen Grabens 700 auch anders ausgebildet werden. Auch ist es möglich ein metallisches Substrat zu verwenden. Ebenfalls ist die Erfindung nicht auf das in Fig. 2 dargestellt Leistungsbauelement 1000 beschränkt, sondern schützt beispielsweise jede Halbleiteranordnung mit beliebigen Bauelementen, die von der Verwendung des Grabens 700 innerhalb der Vertiefung 600 gebrauch macht.

### Bezugszeichenliste

- 100: Siliziumsubstrat
- 110, 120, 130: Substratbereich
- 200: vergrabene Isolatorschicht, SiO₂
- 220: mit Dielektrikum verfüllter tiefer Graben
- 300: monokristallines Siliziumkristall
- 400: Bauelementebereich
- 410: Bereich mit Kristallstörungen
- 510: erste Oxidschicht
- 520: Polysiliziumschicht
- 530: zweite Oxidschicht
- 550, 550': Oxidschicht
- 580, 580': Dielektrikum, Siliziumdioxid
- 600: flacher, geätzter Graben
- 700: tiefer Graben, geätzt
- 701: Wandung des tiefen Grabens
- 702: Boden des tiefen Grabens
- 710: Isoliermaterial, Siliziumdioxid
- 720: Isoliermaterial, Siliziumdioxid
- 750: dotierte Polysiliziumfüllung
- 755: Diffusionsbarriere, Silizid
- 760: Metall, Wolfram, Aluminium
- 800: Hartmaske, Si₃N₄
- 810: Resist, Photolackmaskierung
- 1000: Bauelement, N-DMOS-Feldeffekttransistor
- 1110, 1120,: Metallisierung, Leiterbahn
- 1130,1140 1200: Gate-Elektrode, polykristallines Silizium
- 1300: Feld-Oxid
- 1310: N-Wanne, Driftzone
- 1320: P-Wanne, Body
- 1410: Drainhalbleitergebiet
- 1420: Sourcehalbleitergebiet
- 1430: Bodyanschlusshalbleitergebiet
- 1500: Gate-Oxid
- 1900: Bor-Phosphor-Silicat-Glas
- B: Dotierstoff (Bor) einer Implantation

## Patentansprüche

1. Halbleiteranordnung,
- mit einem Bauelementebereich (400),
- mit einem leitfähigen Substrat (100),
- mit einer vergrabenen Isolatorschicht (200), die den Bauelementebereich (400) gegenüber dem leitfähigen Substrat (100) isoliert,
- mit zumindest einem, mit einem Isolationsmaterial (710) gefüllten Graben (700), der zumindest ein Bauelement (1000) im Bauelementebereich (400) von weiteren Bauelementen im Bauelementebereich (400) isoliert,
- mit einem elektrischen Leiter (750), der mit dem leitfähigen Substrat (100) leitend verbunden ist,
- bei der der elektrische Leiter (750) durch das Isolationsmaterial (710) isoliert in dem Graben (700) angeordnet ist, und
- bei der der Graben (700) innerhalb einer Vertiefung (600) in einer Oberfläche ausgebildet ist.

2. Halbleiteranordnung nach Anspruch 1, mit einem flachen Graben (STI) (600) als Vertiefung.

3. Halbleiteranordnung nach einem der vorhergehenden Ansprüche, bei der die Vertiefung (600) mit Dielektrikum (580) verfüllt ist.

4. Halbleiteranordnung nach einem der vorhergehenden Ansprüche, bei der ein Halbleitergebiet (1430) des zumindest einen Bauelementes (1000) selbstjustiert zur Vertiefung (600) in dem Bauelementebereich (400) ausgebildet ist.

5. Halbleiteranordnung nach einem der vorhergehenden Ansprüche, bei der das leitfähige Substrat (100) eine Anzahl voneinander isolierten Substratbereichen (110, 120, 130) aufweist und bei der die voneinander isolierten Substratbereiche (110, 120, 130) jeweils mit zumindest einem in einem Graben (700) angeordneten elektrischen Leiter (750) leitend verbunden sind.

6. Schaltkreis mit einer Halbleiteranordnung nach einem der vorhergehenden Ansprüche, der Mittel aufweist an dem elektrischen Leiter (750) ein konstantes oder steuerbares Potential anzulegen, wobei von dem konstanten oder steuerbaren Potential zumindest eine elektrische Eigenschaft des zumindest einen Bauelementes (1000) abhängig ist.

7. Verfahren zur Herstellung einer Halbleiteranordnung, bei dem
- ein leitfähiges Substrat (100), ein Bauelementebereich (400) und eine den Bauelementebereich (400) von dem leitfähigen Substrat (100) isolierende Isolatorschicht (200) ausgebildet wird,
- eine flache Vertiefung (600) in einer Oberfläche des Bauelementebereiches (400) geätzt wird,
- innerhalb der flachen Vertiefung (600) ein Graben (700) in den Bauelementebereich (400) bis zur Isolatorschicht (200) geätzt wird,
- anschließend der Graben (700) bis zum leitfähigen Substrat (100) weiter geätzt wird,
- die Wände (701) des Grabens (700) mit einem Isolationsmaterial (710) ausgebildet werden, und
- ein elektrischer Leiter (750) in den Graben (700) eingebracht und mit dem leitfähigen Substrat (100) leitend verbunden wird.

8. Verfahren nach Anspruch 7, bei dem die flache Vertiefung (600) mit Dielektrikum (580') gefüllt wird, und bei dem ein Dotierstoff (B) für ein Halbleitergebiet (1430) des zumindest einen Bauelementes (1000) eingebracht wird, wobei das Dielektrikum (580') in der flachen Vertiefung (600) als Maskierung dient, um das Halbleitergebiet (1430) des zumindest einen Bauelementes (1000) selbst justiert zur Vertiefung (600) in dem Bauelementebereich (400) auszubilden.

9. Verfahren nach einem der vorhergehenden Ansprüche, bei dem zur leitenden Verbindung des elektrischen Leiters (750) mit dem leitfähigen Substrat (100) das Isolationsmaterial (720), das den Boden (701) des Grabens (700) bedeckt, entfernt wird.

10. Verfahren nach einem der vorhergehenden Ansprüche, bei dem zur Ausbildung des Isolationsmaterials (710) ein an den Graben (700) angrenzender Siliziumbereich des Bauelementebereichs (400) oxidiert wird.

11. Verfahren nach einem der vorhergehenden Ansprüche, bei dem vor dem Ätzen des Grabens (700) eine Schichtenfolge aus einer ersten Oxidschicht (510), einer Polysiliziumschicht (520) oberhalb der ersten Oxidschicht (510) und einer zweiten Oxidschicht (530) oberhalb der Polysiliziumschicht (520) auf den Bauelementebereich (400) innerhalb der flachen Vertiefung (600) aufgebracht wird.

12. Verfahren nach Anspruch 11, bei dem die Polysiliziumschicht (520) im Schritt zur Ausbildung des Isolationsmaterials (710) oxidiert wird, und/oder bei dem die zweite Oxidschicht (530) zeitgleich mit der, im Graben (700) offenliegenden vergrabenen Isolatorschicht (200) geätzt wird.
